(19) Europäisches Patentamt
European Patent Office
Office européen des brevets

(11) **EP 2 202 776 B1**

(12) **EUROPÄISCHE PATENTSCHRIFT**

(45) Veröffentlichungstag und Bekanntmachung des Hinweises auf die Patenterteilung:
**15.02.2012 Patentblatt 2012/07**

(51) Int Cl.:
***H01J 37/32*** *(2006.01)*

(21) Anmeldenummer: **08022374.6**

(22) Anmeldetag: **23.12.2008**

(54) **Messverfahren und Messeinrichtung für eine Plasmaversorgungseinrichtung**

Measuring method and device for a plasma supply device

Procédé de mesure et dispositif de mesure pour un dispositif d'alimentation en plasma

(84) Benannte Vertragsstaaten:
**AT BE BG CH CY CZ DE DK EE ES FI FR GB GR HR HU IE IS IT LI LT LU LV MC MT NL NO PL PT RO SE SI SK TR**

(43) Veröffentlichungstag der Anmeldung:
**30.06.2010 Patentblatt 2010/26**

(73) Patentinhaber: **HÜTTINGER Elektronik GmbH + Co. KG**
**79111 Freiburg (DE)**

(72) Erfinder:
• **Thome, Christian**
**79104 Freiburg (DE)**

• **Mann, Ekkehard**
**79194 Gundelfingen (DE)**
• **Glück, Michael**
**79111 Freiburg (DE)**
• **Windisch, Hans-Jürgen**
**79238 Ehrenkirchen (DE)**

(74) Vertreter: **Schiz, Jochen**
**Kohler Schmid Möbus**
**Patentanwälte**
**Ruppmannstrasse 27**
**70565 Stuttgart (DE)**

(56) Entgegenhaltungen:
**EP-A- 1 701 376     EP-A- 1 783 904**
**EP-A- 1 837 893     US-A1- 2005 093 459**

EP 2 202 776 B1

**Beschreibung**

Die Erfindung betrifft eine Vorrichtung zum Bestimmen von zumindest eines mit einer an eine Plasmalast mit einer dynamischen Impedanz durch eine Plasmaversorgungseinrichtung gelieferten Leistung und/oder von der Plasmalast reflektierten Leistung in Beziehung stehenden Parameters, wobei die Plasmaversorgungseinrichtung zwei Hochfrequenzquellen und einen Hybridkoppler umfasst und die Ausgänge der beiden Hochfrequenzquellen an zwei Tore des Hybridkopplers angeschlossen sind, an dessen drittes Tor eine Plasmalast angeschlossen ist, sowie ein Verfahren dazu.

Bei einem Plasma handelt es sich um einen besonderen Aggregatzustand, der aus einem Gas erzeugt wird. Jedes Gas besteht grundsätzlich aus Atomen und/oder Molekülen. Bei einem Plasma ist dieses Gas zu einem Großteil ionisiert. Dies bedeutet, dass durch Zufuhr von Energie die Atome bzw. Moleküle in positive und negative Ladungsträger, also in Ionen und Elektronen, aufgespaltet werden. Ein Plasma eignet sich zur Bearbeitung von Werkstücken, da die elektrisch geladenen Teilchen chemisch hochgradig reaktiv und zudem durch elektrische Felder beeinflussbar sind. Die geladenen Teilchen können mittels eines elektrischen Feldes auf ein Objekt beschleunigt werden, wo sie beim Aufprall einzelne Atome daraus herauslösen können. Die herausgelösten Atome können über Gasfluss abtransportiert werden (Ätzen) oder auf anderen Objekten als Beschichtung abgelagert werden (Herstellung von Dünnfilmen). Anwendung findet eine solche Bearbeitung mittels eines Plasmas vor allem dann, wenn extrem dünne Schichten, insbesondere im Bereich weniger Atomlagen, bearbeitet werden sollen. Typische Anwendungen sind Halbleitertechnik (Beschichten, Ätzen, etc.), Flachbildschirme (ähnlich Halbleitertechnik), Solarzellen (ähnlich Halbleitertechnik), Architekturglasbeschichtung (Wärmeschutz. Blendschutz, etc.), Speichermedien (CD, DVD, Festplatten), dekorative Schichten (farbige Gläser, etc.) und Werkzeughärtung. Diese Anwendungen haben hohe Anforderungen an Genauigkeit und Prozessstabilität. Weiterhin kann ein Plasma auch zur Anregung von Lasern, insbesondere Gaslasern, dienen.

Um aus einem Gas ein Plasma zu generieren, muss ihm Energie zugeführt werden. Das kann auf unterschiedliche Weise, beispielsweise über Licht, Wärme, elektrische Energie, erfolgen. Ein Plasma zur Bearbeitung von Werkstücken wird typischerweise in einer Plasmakammer gezündet und aufrecht erhalten. Dazu wird in der Regel ein Edelgas, z. B. Argon, mit niedrigem Druck in die Plasmakammer geleitet. Über Elektroden und/oder Antennen wird das Gas einem elektrischen Feld ausgesetzt. Ein Plasma entsteht bzw. wird gezündet, wenn mehrere Bedingungen erfüllt sind. Zunächst muss eine geringe Anzahl von freien Ladungsträgern vorhanden sein, wobei zumeist die stets in sehr geringem Maß vorhandenen freien Elektronen genutzt werden. Die freien Ladungsträger werden durch das elektrische Feld so stark beschleunigt, dass sie beim Aufprall auf Atome oder Moleküle des Edelgases weitere Elektronen herauslösen, wodurch positiv geladene Ionen und weitere negativ geladene Elektronen entstehen. Die weiteren freien Ladungsträger werden wiederum beschleunigt und erzeugen beim Aufprall weitere Ionen und Elektronen. Es setzt ein Lawineneffekt ein. Der ständigen Erzeugung von Ionen und Elektronen wirkten die Entladungen bei der Kollision dieser Teilchen mit der Wand der Plasmakammer oder anderen Gegenständen sowie die natürliche Rekombination entgegen, d. h., Elektronen werden von Ionen angezogen und rekombinieren zu elektrisch neutralen Atomen bzw. Molekülen. Deshalb muss einem gezündeten Plasma beständig Energie zugeführt werden, um dieses aufrecht zu erhalten.

Die Energiezufuhr kann über eine Gleichstrom-Versorgungseinrichtung oder eine Wechselstrom-Versorgungseinrichtung erfolgen. Die folgenden Ausführungen beziehen sich auf Wechselstrom-Versorgungseinrichtungen für Hochfrequenz (HF) mit einer Ausgangsfrequenz von > 3 MHz.

Plasmen haben eine sehr dynamische Impedanz, die die gewünschte gleichmäßige HF-Leistungsversorgung schwierig macht. So wechselt während des Zündvorgangs die Impedanz von einem hohen Wert sehr schnell zu einem niedrigen Wert, während des Betriebes können negative Wirkwiderstände vorkommen, die bei steigender Spannung den Stromfluss vermindern, und es kann zu unerwünschten lokalen Entladungen (Arcs) kommen, die das zu bearbeitende Gut, die Plasmakammer oder die Elektroden schädigen können.

Daher müssen Versorgungseinrichtungen für Plasmen (Plasmaversorgungseinrichtungen) für eine hohe Ausgangsleistung und eine hohe reflektierte Leistung ausgelegt sein. EP 1 701 376 A1 hat gezeigt, dass sich derartige Plasmaversorgungseinrichtungen vorteilhaft durch kleinere Hochfrequenzquellen realisieren lassen, deren Ausgangsleistungen durch einen 3-dB-Hybridkoppler (hybrid coupler) gekoppelt werden. Dazu werden zwei Hochfrequenzquellen an zwei Tore (ports) des - Kopplers, im Folgenden Tor 1 und Tor 2 genannt, angeschlossen. Die Hochfrequenzquellen werden so angesteuert, dass ihre Hochfrequenzquellsignale eine Phasenverschiebung von 90˚ zueinander haben. An einem dritten Tor des Hybridkopplers liegt das erste der beiden Hochfrequenzquellsignale relativ zu seinem Eintritt bei Tor 1 um eine Phasenverscheibung von 45˚ nachlaufend und das zweite relativ zu seinem Eintritt bei Tor 2 um 45˚ vorlaufend an. An einem vierten Tor des Hybridkopplers liegt das erste der beiden Hochfrequenzquellsignale um 45˚ vorlaufend und das zweite um 45˚ nachlaufend an. Durch die phasenverschobene Ansteuerung der Hochfrequenzquellen addieren sich ihre Hochfrequenzquellsignate am dritten Tor durch konstruktive Überlagerung (constructive superposition), während sie sich am vierten Tor auslöschen (destructive superposition). Somit benötigen die Hochfrequenzquellen vor dem Koppler jeweils nur die halbe Leistung des erforderlichen Hochfrequenzausgangssignals. Eine Kaskadierung von derartigen Kopplerstufen ist möglich, um Hochfrequenzquellen mit noch weniger Ursprungsleistung einsetzen zu können oder eine noch höhere Leistung des Hochfrequenzausgangssignals zu erzielen.

Die beiden Hochfrequenzquellen können beispielsweise zwei eigenständige Hochfrequenzgeneratoren sein, die durch einen gemeinsamen Steueroszillator angesteuert werden. Dieser Steueroszillator kann für die Hochfrequenz-Steuersignale an seinen beiden Ausgängen eine Phasenverschiebung von 90˚ aufweisen. Die beiden Hochfrequenzquellen können aber auch Verstärkerstufen sein. Solche Verstärkerstufen können insbesondere Schaltverstärker der Klassen D oder E sein. Schaltverstärker der Klasse D können als an sich bekannte Halb- oder Vollbrückenschaltungen realisiert sein. Die Verstärkerstufen können von einem gemeinsamen Hochfrequenztreibersender angesteuert werden, dessen Ausgangssignal beispielsweise über einen zweiten Hybridkoppler aufgespalten wird. Das vierte Tor des Hybridkopplers wird üblicherweise mit einem Abschlusswiderstand der Systemnennimpedanz (oftmals 50 Ω) abgeschlossen.

Den Hochfrequenzquellen wird Energie aus einer Gleichstromversorgung zugeführt. Diese Gleichstromversorgung stellt üblicherweise eine konstante Gleichspannung zur Verfügung.

Bei Fehlanpassung infolge unterschiedlicher Impedanzen von Plasmaversorgungseinrichtung und Plasmalast kommt es zur teilweisen oder vollständigen Reflexion der von der Plasmaversorgungseinrichtung gelieferten Leistung. Die Reflexion ist durch durch den Reflexionsfaktor |Γ| und den Reflexionsphasenwinkel φ bestimmt. Eine Impedanzan-passschaltung (matchbox) kann in bestimmten Bereichen die Impedanz der Plasmalast transformieren und die Reflexion verhindern oder vermindern.

Um die Impedanz der an den Hybridkoppler angeschlossenen Last, bestehend aus der Plasmalast und einer eventuell zwischengeschalteten ImpedanzanpassungsSchaltung zu messen, um Arcs zu erkennen und um die eventuell vorhandene Anpassschaltung mit der notwendigen Information zu ihrer Steuerung zu versorgen, ist es wünschenswert, die in den Hochfrequenzquellen erzeugte Hochfrequenzleistung sowie den Reflexionsphasenwinkel zwischen dem zur Last laufenden und dem von dort reflektierten Hochfrequenzsignal zu kennen.

Es ist bekannt, zur Messung der Leistungen des Hochfrequenzausgangssignal und des von der Last reflektierten Hochfrequenzsignals Richtkoppler einzusetzen und durch Gleichrichtung und Tiefpassfilterung die Hüllkurve der abgegriffenen Messsignale zu bilden.

Die Bestimmung des Reflexionsphasenwinkels des reflektierten Hochfrequenzsignals relativ zum Hochfrequenzausgangssignal wird üblicherweise durch einen Phasenvergleich der beiden noch nicht gleichgerichteten, hochfrequenten Messsignale vorgenommen. Das kann durch Mischung, durch zeitliche Bestimmung der Nulldurchgänge oder durch eine Vektoranalyse der Messsignale erfolgen.

Aufgabe der Erfindung ist es, ein Verfahren und eine Schaltung bereitzustellen, um in einer Plasmaversorgungseinrichtung, die einen Hybridkoppler enthält, den Phasenwinkel der von der Plasmalast reflektierten Hochfrequenzleistung sowie die insgesamt erzeugte Hochfrequenzleistung allein aus Gleichstrom- oder Hüllkurvenmessungen, das heißt ohne Verknüpfung von hochfrequenten Signalen, zu bestimmen und so Werte für die Steuerung und Regelung der Impedanzanpassungsschaltung sowie der Plasmaversorgungseinrichtung zur Verfügung zu stellen, damit auf wechselnde Zustände der Plasmalast unmittelbar reagiert werden kann.

Die Aufgabe wird durch ein Verfahren zum Bestimmen zumindest eines mit einer an eine Plasmalast mit einer dynamischen Impedanz durch eine Plasmaversorgungseinrichtung gelieferten Leistung und/oder von der Plasmalast reflektierten Leistung in Beziehung stehenden Parameters gelöst, mit den Schritten

- Erzeugen von zwei Hochfrequenzquellsignalen gleicher Frequenz mit 90˚ Phasenverschiebung zueinander,
- Koppeln der Hochfrequenzquellsignale in einem Hybridkoppler zu einem Hochfrequenzausgangssignal,
- Senden des Hochfrequenzausgangssignals an die Plasmalast,
- Erfassen von jeweils zumindest einem Messsignal, das mit der Gleichstromleistungsaufnahme der jeweiligen Hochfrequenzquelle in Beziehung steht,
- Mit Hilfe der Messsignale Bestimmen eines Reflexionsphasenwinkels (φ) zwischen dem Hochfrequenzausgangssignal und dem von der Plasmalast reflektierten Hochfrequenzsignal.

Das von der Last, insbesondere einer Plasmalast reflektierte Hochfrequenzsignal tritt in Tor 3 des Hybridkopplers ein und wird dort wieder aufgeteilt (in reflektierte Hochfrequenzteilsignale). Ebenso wie die entsprechenden Hochfrequenzquellsignale wird auch der eine Teil des von der Last reflektierten Hochfrequenzsignals (erstes reflektiertes Hochfrequenzteilsignal) nach dem umgekehrten Weg von Tor 3 nach Tor 1 um 45˚ nachlaufen und der andere Teil der reflektierten Hochfrequenzsignals (zweites reflektiertes Hochfrequenzteilsignal) auf dem Weg von Tor 3 nach Tor 2 um 45˚ vorlaufen.

Die beiden Hochfrequenzquellen geben je einen HF-Strom im Takte ihrer Ansteuerung ab. Mit diesem überlagern sich die reflektierten Hochfrequenzteilsignale jeweils. Zur weiteren Betrachtung können die Ströme der reflektierten Hochfrequenzteilsignale in zwei orthogonale Phasenlagen zerlegt werden, und zwar in die Phasenkomponente, die mit der Phasenlage des Hochfrequenzstroms, der in der Hochfrequenzquelle erzeugt wird (also der Anregung/ Steuerung der Hochfrequenzquelle), übereinstimmt, zum anderen in die mit der dazu orthogonalen Komponente (Quadraturkomponente), die eine entsprechende kapazitive oder induktive Belastung der Hochfrequenzquelle darstellt.

Der gesamte HF-Strom an Tor 3 des Hybridkopplers ist

$$I_{HF3} = 1/\sqrt{2}\ A\cos(\omega t - 45°) + 1/\sqrt{2}\cdot A\sin(\omega t + 45°)$$

$$- 1/\sqrt{2}\ A\,|\Gamma|\cdot[\cos\varphi\cdot\cos(\omega t - 45°) + \cos\varphi\cdot\sin(\omega t + 45°)]$$

$$- 1/\sqrt{2}\ A\,|\Gamma|\cdot[\sin\varphi\cdot\sin(\omega t - 45°) - \sin\varphi\cdot\cos(\omega t + 45°)]$$

$$= \sqrt{2}\ A\cos(\omega t - 45°)$$

$$- \sqrt{2}\ A\,|\Gamma|\cdot[\cos(\varphi)\cdot\cos(\omega t - 45°) + \sin(\varphi)\cdot\sin(\omega t - 45°)]$$

wobei A die Stromamplitude der Hochfrequenzquellen ist. Ersichtlich sind die unterschiedlichen Ansteuerungen der ersten Hochfrequenzquelle (mit cos) und der zweiten Hochfrequenzquelle (mit sin) sowie die unterschiedlichen Verzögerungen beim Weg durch den Hybridkoppler (+/- 45˚). Das Hochfrequenzquellsignal von der ersten Hochfrequenzquelle teilt sich auf die Tore 3 und 4 auf und hat dort je die Hälfte der Leistung, dort also einen Strom von $1/\sqrt{2}$ des Ursprungsstroms; gleiches gilt für die zweite Hochfrequenzquelle. Die konstruktive Überlagerung an Tor 3 ergibt $\sqrt{2}$ A für den Strom, also doppelte Leistung.

Interessant sind die Amplitude des Hochfrequenzstroms an Tor 3

$$\hat{I}_3 = \sqrt{2}\ A\ \sqrt{(1 - |\Gamma|\cdot\cos^2\varphi) + (|\Gamma|\cdot\sin^2\varphi)} = \sqrt{2}\ A\ \sqrt{1 - |\Gamma|\cdot\cos\varphi + \Gamma^2}$$

und die Amplitude der Hochfrequenzspannung an Tor 3

$$\hat{U}3 = \sqrt{2}\ A\ \sqrt{(1 + |\Gamma|\cdot\cos^2\varphi) + (|\Gamma|\cdot\sin^2\varphi)} = \sqrt{2}\ A\ \sqrt{1 + |\Gamma|\cdot\cos\varphi + \Gamma^2}$$

Der Monentanwert des Stroms an der ersten Hochfrequenzquelle (Tor 1) beträgt

$$I_1 = A\cos(\omega t) - \sqrt{2}\,|\Gamma|[\cos\varphi\cdot\cos(\omega t - 2\cdot 45°) + \sin\varphi\cdot\sin(\omega t - 2\cdot 45°)]$$

$$= A\cos(\omega t)\cdot[1 + \sqrt{2}\,|\Gamma|\cdot\sin\varphi] - A\sqrt{2}\,|\Gamma|\cdot\cos\varphi\cdot\sin(\omega t)$$

und an der zweiten Hochfrequenzquelle (Tor 2)

$$I_2 = A \sin(\omega t) \cdot \sqrt{2} \, |\Gamma| \left[\cos\varphi \cdot \cos(\omega t + 2 \cdot 45°) + \sin\varphi \cdot \sin(\omega t + 2 \cdot 45°)\right]$$

$$= A \sin(\omega t) \cdot [1 - \sqrt{2} \, |\Gamma| \cdot \sin\varphi] + A \sqrt{2} \, |\Gamma| \cdot \cos\varphi \cdot \sin(\omega t)$$

Das eine reflektierte Hochfrequenzteilsignal wird nach dem Weg von Tor 3 nach Tor 1 ebenfalls wieder um 45° in der Phase nachlaufen, entsprechendes Vorlaufen gilt für den Weg des anderen reflektierten Hochfrequenzteilsignals von Tor 3 nach Tor 2.

Insbesondere beim Einsatz von Schaltverstärkern wird der Stromanteil des reflektierten Hochfrequenzteilsignals, dessen Phasenlage orthogonal zur Phase des von der Hochfrequenzquelle abgegebenen Hochfrequenzstroms liegt, im Wesentlichen an der Hochfrequenzquelle wieder reflektiert, während der Stromanteil des reflektierten Hochfrequenzteilsignals, dessen Phasenlage in Richtung der Phase des von der Hochfrequenzquelle abgegebenen Hochfrequenzstroms liegt, sich je nach Vorzeichen zu diesem addieren oder sich davon subtrahieren wird. Damit ändert sich die Gleichstromleistungsaufnahme der Hochfrequenzquelle entsprechend. Somit kann von der Gleichstromleistungsaufnahme der Hochfrequenzquellen auf den Reflexionsphasenwinkels $\varphi$ des von der Last reflektierten Hochfrequenzsignals relativ zum Hochfrequenzausgangssignal geschlossen werden.

Der resultierende Hochfrequenzstrom der ersten Hochfrequenzquelle in der Phasenlage ihrer Ansteuerung ist also

$$I_{1inphase} = A \cos(\omega t) \cdot [1 + \sqrt{2} \, |\Gamma| \cdot \sin\varphi] \, ;$$

und der resultierende Hochfrequenzstrom der zweiten Hochfrequenzquelle in der Phasenlage ihrer Ansteuerung

$$I_{2inphase} = A \sin(\omega t) \cdot [1 - \sqrt{2} \, |\Gamma| \cdot \sin\varphi].$$

Da die den Hochfrequenzquellen zugeführte Gleichspannung bei Verwendung einer Gleichspannungsquelle konstant ist, ist die Messung der Eingangsgleichströme $J_{oc}$ ausreichend.

Insbesondere ist die Differenz der Eingangsgleichströme beider Hochfrequenzquellen ein sehr gutes Maß für den Reflexionsphasenwinkel $\varphi$. Für die unterschiedliche Belastung der Gleichspannungsquellen ergibt sich

$$\Delta J_{DC} = J_{DC1} - J_{DC2} \sim \hat{I}_{1inphase} - \hat{I}_{2inphase}$$

$$= A \cdot [1 + \sqrt{2} \, |\Gamma| \cdot \sin\varphi - 1 + \sqrt{2} \, |\Gamma| \cdot \sin\varphi]$$

$$= 2 A \sqrt{2} \, |\Gamma| \cdot \sin\varphi$$

$$\sin\varphi \sim \frac{\Delta J_{DC}}{A \, |\Gamma|} \, .$$

Das Verhältnis der maximalen Eingangsgleichstromdifferenz zur reflektierten Hochfrequenzleistung kann einmal gemessen werden und führt zu einem Eichfaktor *k*.

Bei einer Messung kann jeweils die Eingangsstromdifferenz $\Delta J_{DC}$ mit der reflektierten Hochfrequenleistung normiert und als eine mit dem Phasenwinkel in Beziehung stehende Größe ein vorläufiger Phasenwinkel von

$$\varphi_\rho = \arcsin\left(\frac{\Delta J_{DC}}{kA\Gamma}\right)$$ ermittelt werden. Versuche haben bestätigt, dass die Differenz der Eingangsgleichströme der Hochfrequenzquellen dieser Gleichung in guter Näherung genügt. Den Reflexionsfaktor $|\Gamma|$ erhält man durch eine übliche Messung der Hüllkurven der vor- und rückwärtslaufenden Hochfrequenzwellen an einem Richtkoppler an Tor 3 des Hybridkopplers, die Amplituden der Hochfrequenzquellsignale $A$ kann nach einer Eichung aus der Summe der Eingangsgleichströme $J_{DCl} + J_{DC2}$ gewonnen werden.

Da die bei der Bestimmung des Phasenwinkels verwendete Arcussinus-Funktion kein eindeutiges Ergebnis für den gesamten Winkelbereich $0...2\pi$ bzw. $-\pi...\pi$ liefert, ist es vorteilhaft, noch den Zweig zu bestimmen. Dafür können gemäß einer Variante der Erfindung die Amplituden an Tor 3 des Kopplers verwendet werden. Hier liegt das überlagerte Signal aus dem Hochfrequenzausgangssignal und dem von der Last reflektierten Hochfrequenzsignal an. Die Amplitude des Hochfrequenzstroms ist

$$\hat{I}_3 \approx \sqrt{1 - 2|\Gamma|\cos\varphi + \Gamma^2}$$

und die Amplitude der Hochfrequenzspannung ist

$$\hat{U}_3 \approx \sqrt{1 + 2|\Gamma|\cos\varphi + \Gamma^2}$$

Schon aus einem dieser Signale läßt sich bei bekanntem Reflexionsfaktor über den Zweig entscheiden.

$$\varphi = \begin{cases} -\arcsin\left(\dfrac{\Delta J_{DC}}{kA|\Gamma|}\right) + 180°, \text{ falls } \hat{I}_3^2 < 2A^2\left(1+\Gamma^2\right) \\[4ex] \arcsin\left(\dfrac{\Delta J_{DC}}{kA|\Gamma|}\right) \text{ sonst} \end{cases}$$

Alternativ zur Messung des Stroms an Tor 3 kann auch eine Hilfswicklung durch den Hybridkoppler oder in räumlicher Nähe des Hybridkopplers so angebracht werden, dass sie von den magnetischen Feldlinien des Hybridkopplers durchdrungen wird. Enthält der Koppler Spulenkerne oder Ferrite zur Erhöhung der Magnetisierung, so kann die Hilfswicklung in der Nähe dieser Spulenkerne oder Ferrite angebracht sein. Die Amplitude des in der Hilfswicklung induzierten Hochfrequenzstroms ist ein Maß für den Gesamtstrom durch den Koppler. Auch mit dieser Information kann über den zutreffenden Zweig der Arcussinus-Funktion entschieden werden.

Findet bei der Bedingung $\hat{I}_3^2 < 2A^2\left(1+\Gamma^2\right)$ keine Korrektur für $|\Gamma|$ statt, ist der Winkelfehler durch eine mögliche Entscheidung für den falschen Arcussinus-Zweig bei niedrigem $\Gamma$ relativ gering. Dies gilt ebenso für eine Entscheidung, die mit Hilfe eines Signals aus einer Hilfswicklung getroffen wird.

Um die Messwerte für Spannung und Strom beziehungsweise ihre Quadrate für die folgende Berechnung vergleichbar zu machen, werden von der Schaltung abhängige Normierungsfaktoren a und b eingeführt. Die Differenz der Quadrate von Spannungs- und Stromamplitude ergibt

$$|\Gamma|\cos\varphi \sim a \cdot \hat{U}_3^2 - b \cdot \hat{I}_3^2$$

$$\cos \varphi \sim \frac{a \cdot \hat{U}_3^2 - b \cdot \hat{I}_3^2}{|\Gamma|}$$

Die Normierungsfaktoren kann man beispielsweise durch eine Testlastimpedanz mit konstantem Reflexionsfaktor $|\Gamma|$ und einstellbarem Reflexionsphasenwinkel $\varphi$ ermitteln und entsprechende Eichwerte generieren. Damit kann die Entscheidung für einen Arcussinus-Zweig ohne Kenntnis von $|\Gamma|$ erfolgen.

Eine noch höhere Genauigkeit des Reflexionsphasenwinkels $\varphi$ erhält man, wenn man für dessen Berechnungen die Arcustangens-Funktion einsetzt, wobei $\tan \varphi$ aus den nun bekannten orthogonalen Funktionen $\cos \varphi$ und $\sin \varphi$ folgt.

$$\varphi = \arctan c \, \frac{\Delta J_{DC}}{A \cdot \left( a \cdot \hat{U}_3^2 - b \cdot \hat{I}_3^2 \right)}$$

Mit dem nun bekanntem Reflexionsphasenwinkel $\varphi$ kann auch der Reflexionsfaktor $|\Gamma|$ errechnet werden. Der Normierungsfaktor c kann beispielsweise wieder durch eine Eichmessung mit einer Testlastimpedanz ermittelt werden. In dieser Anordnung ist kein Einsatz eines Richtkopplers erforderlich, stattdessen können allein aus der Messung der Eingangsgleichströme und der Hüllkurven von Hochfrequenzstrom und -spannung an Tor 3 des Hybridkopplers der Reflexionsfaktor und der Reflexionsphasenwinkel bestimmt werden.

Die so gewonnenen Reflexionsphasenwinkel, Reflexionsfaktor und/oder Leistung des Hochfrequenzausgangssignals können zur Steuerung oder Regelung der erzeugten Hochfrequenzausgangsleistung verwendet werden. Dadurch kann eine konstante Einspeisung elektrischer Leistung in das Plasma gewährt werden, wie es insbesondere für Prozesse mit konstanten Abscheide- oder Ätzraten oder für Laser mit konstanter Ausgangsleistung gefordert ist. Insbesondere können aus den ermittelten Größen Fehlerzustände abgeleitet werden. Die Verarbeitung der Messsignale kann in einer Schaltung erfolgen, die die Messsignale digital verarbeitet. Insbesondere kann eine solche Schaltung einen digitalen Signalprozessor enthalten. Dazu können die Messsignale zuvor in A/D-Wandlern digitalisiert worden sein. Eine Tabelle kann Eich- und Korrekturwerte enthalten. Aus einer Tabelle von gespeicherten Fehlerzuständen kann eine Steuerung bzw. digitale Signalverarbeitung auswählen, bei welchen Fehlerzuständen wie reagiert werden soll. Ein Expertensystem oder ein neuronal vernetztes System können die Regelung stetig verbessern und neue Fehlersituationen erlernen und entsprechend auf Fehler reagieren. Die Regelung der Hochfrequenzquelle kann auch durch Fuzzy-Logik erfolgen.

Weiterhin können die ermittelten Größen dazu verwendet werden, eine Impedanztransformation zwischen der Plasmaversorgungseinrichtung und der Plasmalast zu steuern.

Die Erfindung betrifft auch eine Vorrichtung zum Bestimmen zumindest eines mit einer an eine Plasmalast mit einer dynamischen Impedanz durch eine Plasmaversorgungseinrichtung gelieferten Leistung und/oder von der Plasmalast reflektierten Leistung in Beziehung stehenden Parameters, wobei die Plasmaversorgungseinrichtung zwei Hochfrequenzquellen aufweist, deren Ausgänge an je ein Tor eines Hybridkopplers angeschlossen sind, und an seinem dritten Tor, an dem sich die Hochfrequenzquellsignale konstruktiv überlagern, die Plasmalast ausschließbar oder angeschlossen ist, wobei jeder der beiden Hochfrequenzquellen eine erste Messeinrichtung zugeordnet ist, die Messsignale erzeugt, die mit der Gleichstromleistungsaufnahme der jeweiligen Hochfrequenzquelle in Beziehung steht, und die erste Messeinrichtungen an eine Auswerteeinrichtung angeschlossen sind, die ausgebildet ist, aus den Messsignalen mindestens einen Reflexionsphasenwinkel, der zwischen dem Hochfrequenzausgangssignal und dem von der Plasmalast reflektierten Hochfrequenzsignal vorliegt, zu ermitteln.

Die Hochfrequenzquellen können auch durch entsprechend angesteuerte Generatoren oder Verstärker oder auch durch zwei Tore eines von einem Generator gespeisten zweiten Hybridkopplers dargestellt sein. Jede Hochfrequenzquelle kann auch ihrerseits wieder aus einer Anordnung von weiteren Hochfrequenzquellen bestehen, die über weitere Hybridkoppler zusammengekoppelt werden. Die Hochfrequenzquellen können schaltende Elemente aufweisen. Wenn den schaltenden Elemente aktive Treiber zugeordnet sind und jeder Treiber individuell angesteuert werden kann und somit Dauer und Zeitpunkt des Einschaltens der schaltenden Element für jedes schaltende Element individuell gesteuert werden können, kann dies unter Berücksichtigung der ermittelten Hochfrequenz-Parameter zuverlässig und exakt erfolgen.

Zumindest einer Hochfrequenzquelle kann eine DC-Stromversorgung zugeordnet sein, wobei die Hochfrequenzquelle aus einer DC-Spannung ein Hochfrequenzquellsignal generiert.

Die zu speisende Plasmalast ist entweder direkt oder durch Zwischenschaltung weiterer Einheiten, wie beispielsweise einer impedanzanpassungsschaltung, an das dritte Tor des Hybridkopplers angeschlossen.

An das vierte Tor des ersten Hybridkopplers kann ein Abschlusswiderstand angeschlossen sein.

Es kann mindestens eine weitere Messeinrichtung zur Erzeugung eines Messsignals, das mit der Amplitude der Spannung oder des Stroms des Hochfrequenzausgangssignals oder mit der Amplitude des Stromflusses durch den Hybridkoppler in Beziehung steht, vorgesehen sein, wobei die ersten und weitere(n) Messeinrichtung(en) an die Auswerteeinheit (oder eine andere Auswerteeinheit) angeschlossen sein können. Der Auskoppelpunkt für die Messeinrichtung braucht nicht unmittelbar am Tor des Hybridkopplers liegen, sondern kann bei Tor 3 in Richtung der impedanzanpassungsschaltung oder der Plasmalast verschoben sein.

Die Messeinrichtungen für die Messsignale, die aus Hochfrequenzsignalen gewonnen werden, können beispielsweise Ankoppelwiderstände und Dioden sein. Insbesondere können Einhüllende von HF-Signalen gemessen werden. Zur Glättung jedes Messsignals kann der jeweiligen Messeinrichtung ein Tiefpassfilter nachgeschaltet sein, das die restlichen hochfrequenten Spektralanteile blockiert. Das so gewonnene Messsignal steht mit der Amplitude des Hochfrequenzsignals an dem betreffenden Tor des Hybridkopplers in Beziehung. DC-Ströme können dagegen direkt durch entsprechende an sich bekannte Messeinrichtungen gemessen werden.

Die Ausgänge der Messeinrichtungen für die Messsignale bzw. der nachgeschalteten Tiefpassfilter sind an eine Auswerteeinrichtung angeschlossen, die aus den Messsignalen die gewünschten Parameter ermitteln kann.

Da es für die Ermittlung von Phasenwinkel und/oder Leistung von Vorteil ist, wenn die Messsignale die jeweilige Hochfrequenzleistung, die jeweilige Hochfrequenzspannung oder der jeweilige Hochfrequenzstrom an der betreffenden Auskoppelstelle repräsentieren, können die Messeinrichtungen entsprechend ausgelegt oder geeicht sein. Alternativ kann eine Umrechnung der Messsignale in Signale, die den genannten Größen entsprechen, vor oder in der Auswerteinrichtung erfolgen.

Für die Gewinnung linear unabhängiger Überlagerungen von vorwärts- und zurücklaufenden Hochfrequenzsignalen ist es vorteilhaft, auch an Tor 3 des Hybridkopplers, an das die Plasmalast angeschlossen ist, eine Messeinrichtung zum Erzeugen eines Messsignal anzuschließen.

Da die Messsignale nur den Änderungen der Impedanz der Plasmalast beziehungsweise Änderungen der erzeugten Hochfrequenz folgen und nicht dem Momentanwert des Hochfrequenzsignals, sind die zu verarbeitenden Frequenzen niedrig genug, um die Verarbeitung der Messignale und die Ermittlung der gewünschten Größen auch von einer digitalen Schaltung ausführen zu lassen. Eine solche Schaltung kann auch ein digitaler Signalprozessor oder ein Mikrocontroller sein oder einen solchen aufweisen. Dazu muss das jeweilige Messsignal zuvor mit Hilfe eines A/D-Wandlers digitalisiert werden.

Die Auswerteeinheit kann an mindestens eine der Hochfrequenzquelten angeschlossen sein, um diese zu steuern. Weiterhin kann die Auswerteeinheit an die Impedanzanpassungsschaltung angeschlossen sein, um die darin stattfindende Impedanztransformation zu steuern. Zu diesem Zweck kann eine Steuerteitung von der Auswerteschaltung zur Impedanzanpassungsschaltung führen. Außerdem kann von der Auswerteeinrichtung eine Steuerleitung zu den Hochfrequenzquellen führen.

Die Erfindung soll nun anhand der nachfolgenden Figuren erläutert werden, wobei die Figuren 1 bis 3 je ein Ausführungsbeispiel zeigen. Für entsprechende Elemente oder Signale werden in den unterschiedlichen Figuren gleiche Bezugsziffern verwendet.

Es zeigen:

Figur 1      eine Plasmaversorgungseinrichtung mit schematischer Darstellung der Messsignalerfassung;

Figur 2      eine Plasmaversorgungseinrichtung mit Messsignalerfassung und Auswerteeinrichtung;

Figur 3      eine Plasmaversorgungseinrichtung mit Messsignalerfassung und Auswerteeinrichtung;

Figur 4      die Hochfrequenzströme an Tor 1 des Hybridkopplers in Abhängigkeit vom Phasenwinkel $\varphi$;

Figur 5      die Hochfrequenzspannung und den Hochfrequenzstrom an Tor 3 sowie die in Phase mit der jeweiligen Anregung liegenden Hochfrequenzströme an den Toren 1 und 2 des Hybridkopplers in Abhängigkeit vom Reflexionsphasenwinkels $\varphi$;

Figur 6      die normierte Differenz der in Phase mit der jeweiligen Anregung liegenden Hochfrequenzströme an den Toren 1 und 2 sowie die normierte Differenz der Quadrate von Hochfrequenzspannung und Hochfrequenzstrom an Tor 3 des Hybridkopplers;

Figur 7      der maximale Fehler eines mit der Arcussinus-Funktion bestimmten Reflexionsphasenwinkels $\varphi$.

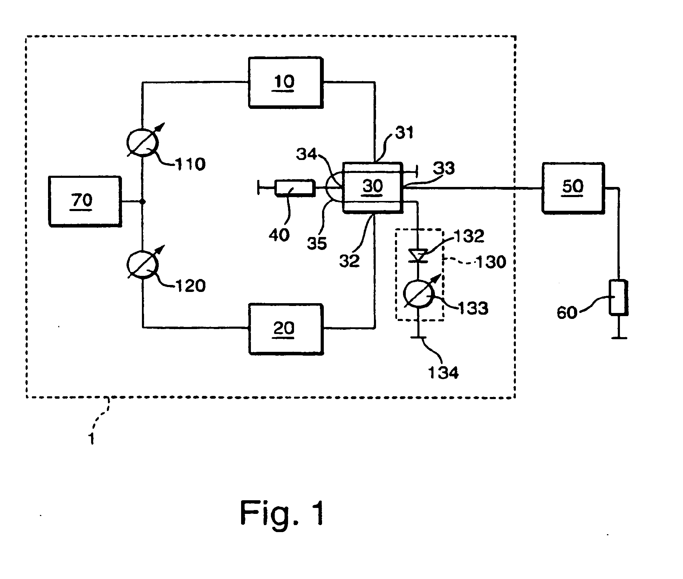

Figur 1 ist eine schematische Darstellung einer Plasmaversorgungseinrichtung 1, die zwei Hochfrequenzquellen 10, 20, einen Hybridkoppler 30 mit vier Toren 31, 32, 33, 34, einen Abschlusswiderstand 40 sowie Messeinrichtungen 110, 120 und 130 aufweist. An den Ausgang der Plasmaversorgungseinrichtung 1, der mit Tor 33 in Verbindung steht, ist eine Impedanzanpassungsschaltung 50 und an diese die hier nur als Impedanz dargestellte Plasmalast 60 angeschlossen.

Die beiden Hochfrequenzquellen 10, 20 sind an die Tore 31 bzw. 32 angeschlossen und liefern je ein Hochfrequenzquellsignal an den Hybridkoppler 30, wobei die Hochfrequenzquelle 10 so angesteuert wird, dass ihr Signal gegenüber dem der Hochfrequenzquelle 20 in der Phase um 90˚ vorauseilt.

Die beiden Hochfrequenzquellen 10, 20 können beispielsweise um 90˚ phasenverschoben angesteuerte eigenständige Generatoren, entsprechend getriebene Verstärker oder auch nur die Ausgänge eines Hybridkopplers oder Leistungsteilers mit 90˚ Phasenverschiebung sein.

Die Hochfrequenzquellen 10, 20 sind an eine Gleichstromversorgung 70 angeschlossen. Die Eingangsgleichströme können über die Messeinrichtung 110, 120 gemessen werden.

Der Hybridkoppler 30 verzögert das Hochfrequenzsignal der Hochfrequenzquelle 10 auf dem Weg von Tor 31 nach Tor 33 um einen Phasenwinkel von 45˚, während er das Hochfrequenzsignal der Hochfrequenzquelle 20 auf dem Weg von Tor 32 nach Tor 33 um 45˚ voreilen lässt. Dadurch liegen an Tor 33 beide Hochfrequenzquellsignale konstruktiv überlagert an.

Beim Weg zum Tor 34 liegen umgekehrte Verhältnisse vor. Der Hybridkoppler 30 lässt das Hochfrequenzsignal der Hochfrequenzquelle 10 auf dem Weg von Tor 31 nach Tor 34 um 45˚ voreilen, während er das Hochfrequenzsignal der Hochfrequenzquelle 20 auf dem Weg von Tor 32 nach Tor 34 um 45˚ verzögert. Dadurch liegen an Tor 34 beide Hochfrequenzquellsignale destruktiv überlagert an und löschen sich damit aus.

Eventuell von der Plasmalast 60 bzw. der impedanzanpassungsschaltung 50 reflektierte Hochfrequenzsignale kommen zum Tor 33 des Richtkopplers 30 zurück, werden in Hochfrequenzteilsignale aufgeteilt und diese werden über die beiden Tore 31, 32 in Richtung der beiden Hochfrequenzquellen 10, 20 gesendet. Werden diese zurücklaufenden Hochfrequenzteilsignale an den beiden Hochfrequenzquellen 10, 20 wiederum reflektiert, haben diese beiden HF-Teilsignale nach dem abermaligen Durchgang durch den Hybridkoppler eine solche Verzögerung bzw. Beschleunigung erfahren, dass sie sich an Tor 33 auslöschen und nur an Tor 34 konstruktiv überlagern, an dem der Abschlusswiderstand 40 angeschlossen ist.

Am Tor 33 liegt das überlagerte Signal aus dem Hochfrequenzausgangssignal und dem von der Last 60 reflektierten Hochfrequenzsignal an. Ein mit diesem Signal in Beziehung stehendes Messsignal kann über die Messeinrichtung 130 gemessen werden, welche an die Hilfswicklung 35 des Hybridkopplers 30 angeschlossen ist. Die Messeinrichtung 130 umfasst einen Detektor 132 zur Gleichrichtung, der in dieser Ausführungsform als Diode ausgebildet ist, und ein Messinstrument 133, dessen zweiter Anschluss an Masse 134 gelegt ist. Mit der Messeinrichtung 130 lässt sich die mit dem Detektor 132 gewonnene Spannung beobachten, die mit der Amplitude des Hochfrequenzsignals an Tor 33 des Kopplers 30 in Beziehung steht.

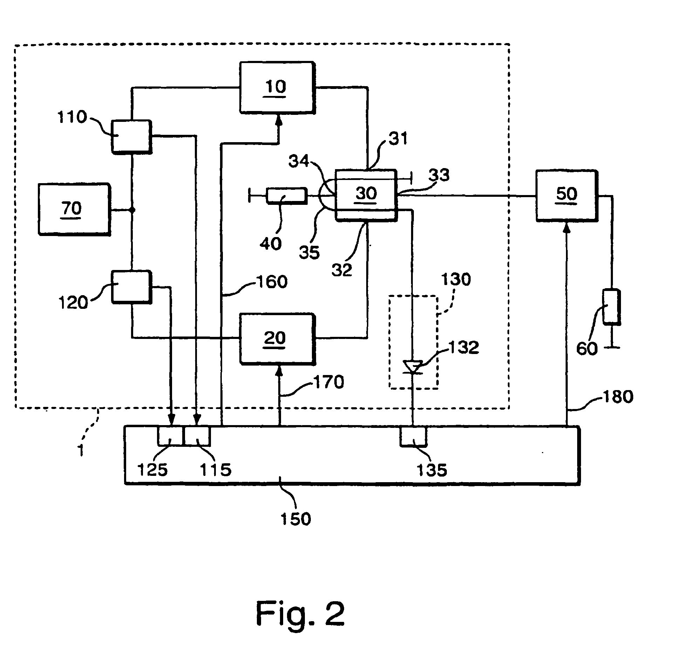

Figur 2 zeigt ein zweites Ausführungsbeispiel einer Plasmaversorgungseinrichtung 1 mit den Hauptteilen, die schon aus Figur 1 bekannt sind. Die Messeinrichtung 130 ist wieder an die Hilfswicklung 35 des Hybridkopplers 30 angeschlossen. Die Messeinrichtung 130 umfasst lediglich den Detektor 132. Anstelle des Messinstruments ist eine Auswerteeinheit 150 vorgesehen, die an ihren drei Eingängen mit Analog-Digital-Wandlern 115, 125, 135 ausgestattet ist, welche die Messsignale digitalisieren. Die weitere Verarbeitung und Auswertung der Messsignale erfolgt in der Auswerteeinrichtung 150. Die Auswerteeinrichtung 150 kann auch ganz oder zum Teil die Steuerung der Hochfrequenzquellen 10 und 20 sowie die der Impedanzanpassungsschaltung 50 übernehmen, mit denen sie zu diesem Zweck jeweils mit Steuerleitungen 160, 170, 180 verbunden ist. Auf diese Weise kann beispielsweise durch Steuerung der Hochfrequenzquellen 10, 20 die Leistung des Hochfrequenzausgangssignals am Tor 33 des Hybridkopplers 30 konstant gehalten werden, oder es kann die Impedanz der Plasmalast 60 durch die Impedanzdanpassungsschaltung 50 der Ausgangsimpedanz der Plasmaversorgungseinrichtung 1 angepasst werden.

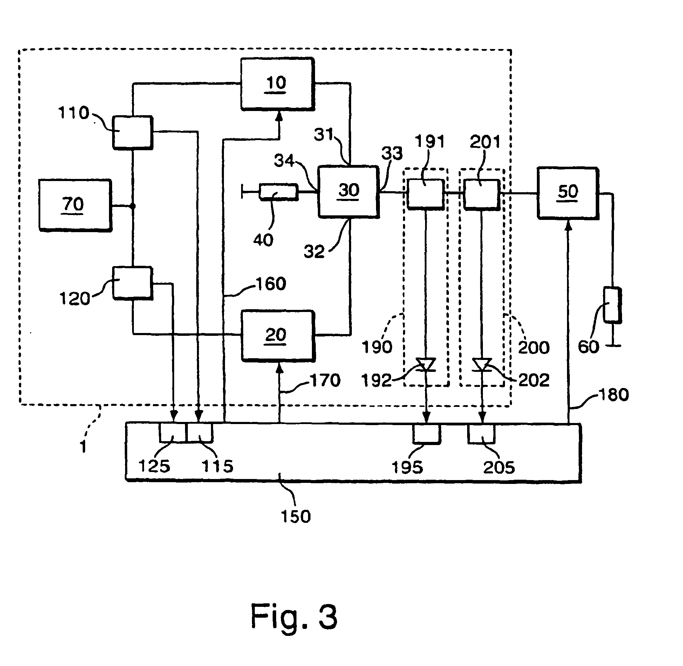

Bei der Ausführungsform gemäß Figur 3 ist im Unterschied zur Ausführungsform der Figur 2 kein als Hilfwicklung ausgebildetes Auskoppelelement am Hybridkoppler 30 vorgesehen. Vielmehr sind die Messeinrichtungen 190, 200 an das Tor 33 des Hybridkopplers 30 angeschlossen. Durch die Messeinrichtungen 190, 200 können der HF-Strom und die HF-Spannung am Tor 33 erfasst werden. Zu diesem Zweck weisen die Messeinrichtungen 190, 200 beispielsweise als Widerstände ausgebildete Auskoppelelemente 191, 201 auf. Diesen folgen Detektoren 192, 202 zur Gleichrichtung, die in diesem Ausführungsbeispiel als Dioden ausgebildet sind. Die Messeinrichtungen 190, 200 sind wieder unmittelbar mit Analog/Digital-Wandlern 195, 205 der Auswerteeinheit 150 verbunden.

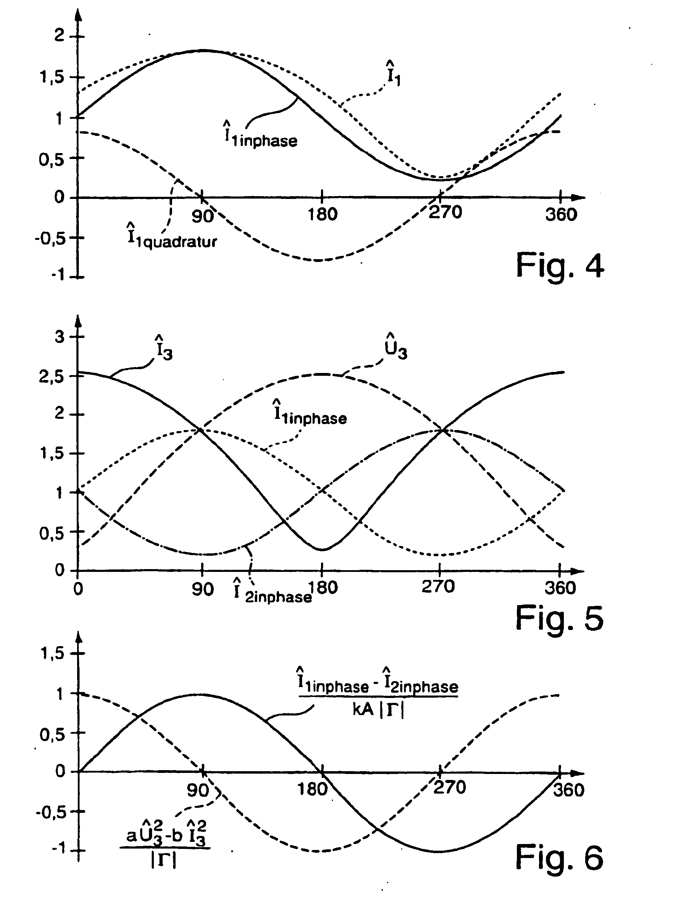

In der Figur 4 sind die Hochfrequenzströme am Tor 31 dargestellt. Insbesondere beim Einsatz von Schaltverstärkem als Hochfrequenzquellen 10, 20 wird der Stromanteil des reflektierten Hochfrequenzteilsignals, dessen Phasenlage orthogonal zur Phase des von der Hochfrequenzquelle abgegebenen Hochfrequenzstroms liegt, im Wesentlich von der Hochfrequenzquelle wieder reflektiert, während der Stromanteil des reflektierten Hochfrequenzteilsignals, dessen Phasenlage in Phase in Richtung der Phase des von der Hochfrequenzquelle abgegebenen Hochfrequenzstorms liegt, sich je nach Vorzeichen zu diesem addiert oder sich davon subtrahiert.

Der resultierende Hochfrequenzstrom der ersten Hochfrequenzquelle 10 in der Phasenlage ihrer Ansteuerung ist der Strom $I_{1\text{ inphase}}$, der Strom mit dazu orthogonaler Phasenlage ist der Strom $\hat{I}_{\text{iquatratur}}$. $\hat{I}_1$ ist die Zeigerlänge der beiden Teilströme, also die Amplitude des Hochfrequenzstroms aufgetragen über den Reflexionsphasenwinkel $\varphi$. Der Reflexionsfaktor $|\Gamma|$ ist für das in Figur 4 gezeigte Ausführungsbeispiel = 0,8. Wie sich aus den Figuren 1 bis 3 ergibt, ist am Tor 31 keine Messeinrichtung vorgesehen, um die in der Figur 4 gezeigten Ströme zu messen. Dies ist auch nicht nötig, da der von der Gleichstromversorgung 70 zur Hochfrequenzquelle 10 fließende Strom durch die Messeinrichtung 110 gemessen werden kann. Dieser Strom verhält sich wie $\hat{I}_{1\text{ inphase}}$. Entsprechend verhält sich der Strom, der von der Gleichstromversorgung 70 zur Hochfrequenzquelle 20 fließt, wie der Strom $\hat{I}_{2\text{ inphase}}$, der am Tor 32 des Hybriskopplers 30 anliegt. Es ist daher auch ausreichend, den Eingangsgleichstrom mit der Messeinrichtung 120 zu messen.

Die Figur 5 zeigt die Ströme $\hat{I}_{1\text{ inphase}}$ an Tor 31 und $\hat{I}_{2\text{ inphase}}$ an Tor 32. Um den Phasenwinkel des an der Last 60 reflektierten Hochfrequenzsignals und die Ausgangsleistung der Plasmaversorgungseinrichtung 1 zu ermitteln, bietet es sich an, die Differenz dieser beiden Ströme beziehungsweise die Differenz der korrespondierenden Eingangsgleichströme zu verwenden. Im Gegensatz zu den Strömen $\hat{I}_{1\text{ inphase}}$ und $\hat{I}_{2\text{ inphase}}$, die ungerade Funktionen über $\varphi$ sind, sind die Signale $\hat{I}_3$ und $\ddot{U}_3$, also der Hochfrequenzstrom und die Hochfrequenzspannung am Tor 33, gerade Funktionen über $\varphi$. Daher bietet es sich an, zur Ermittlung des Phasenwinkels sowohl $\Delta\hat{I}$ beziehungsweise $\Delta J_{DC}$ und

$$\dot{U}_3^2 - \hat{I}_3^2 \text{ zu verwenden.}$$

Wie oben bereits beschrieben, kann aus der Differenz der Eingangsgleichströme ein vorläufiger, noch nicht eindeutiger Phasenwinkel ermittelt werden. Mit Hilfe der Amplituden der Hochfrequenzspannung und des Hochfrequenzstroms am Tor 33 kann der Phasenwinkel dann genau bestimmt werden.

In der Figur 6 sind die mit der reflektierten Leistung normierte Differenz von $\hat{I}_{1,\text{ inphase}} - \hat{I}_{21\text{ inphase}}$ sowie die mit der reflektierten Leistung normierter und mit entsprechenden Faktoren a, b (siehe oben) versehene Differenz

$$\left(\dot{U}_3^2 - \hat{I}_3^2\right)/|\Gamma| \text{ dargestellt.}$$ Um den Phasenwinkel zu bestimmen, genügt es, aus der zweiten Kurve nur das Vorzeichen zu verwenden. Aus der Amplitude des Stroms am Tor 33 kann mit Hilfe der Ausgangsleistung eine normierte Lastimpedanz berechnet werden. Anhand dieser Impedanz kann bestimmt werden, ob der berechnete vorläufige Phasenwinkel im Bereich -180˚ bis 0˚ liegt oder Bereich 0˚ bis 180˚ liegt.

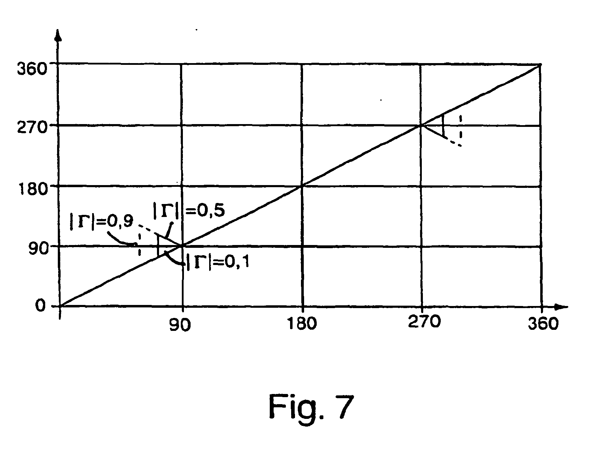

In Figur 7 ist der Fehler für drei verschiedene Reflexionsfaktoren $|\Gamma|$ aufgezeichnet, der bei der Bestimmung des Reflexionsphasenwinkels $\varphi$ mit Hilfe der Arcussinus-Funktion auftritt, wenn wegen mangeinder Korrektur mit (1 + $\Gamma^2$) das Segment allein aus $\hat{I}_3^2 < 2A^2$ bestimmt wird.

## Patentansprüche

1. Verfahren zum Bestimmen zumindest eines mit einer an eine Plasmalast mit einer dynamischen Impedanz durch eine Plasmaversorgungseinrichtung gelieferten Leistung und/oder von der Plasmalast reflektierten Leistung in Beziehung stehenden Parameters, mit den Schritten

   - Erzeugen von zwei Hochfrequenzquellsignalen gleicher Frequenz mit 90˚ Phasenverschiebung zueinander,
   - Koppeln der Hochfrequenzquellsignale in einem Hybridkoppler zu einem Hochfrequenzausgangssignal,
   - Senden des Hochfrequenzausgangssignals an die Plasmalast,
   - Erfassen von jeweils zumindest einem Messsignal, das mit der Gleichstromleistungsaufnahme der jeweiligen Hochfrequenzquelle, in Beziehung steht,
   - mit Hilfe der Messsignale Bestimmen eines Reflexionsphasenwinkels ($\varphi$) zwischen dem Hochfrequenzausgangssignal und dem von der Plasmalast reflektierten Hochfrequenzsignal.

2. Verfahren nach Anspruch 1, weiter **dadurch gekennzeichnet, dass** als Messsignale Signale verwendet werden, die mit den Eingangsgleichströmen der Hochfrequenzquellen in Beziehung stehen.

3. Verfahren nach einem der vorhergehenden Ansprüche, weiter **dadurch gekennzeichnet, dass** zunächst ein vorläufiger Reflexionsphasenwinkel ($\varphi$) unter Verwendung der Messsignale bestimmt wird.

4. Verfahren nach einem der vorhergehenden Ansprüche, weiter **dadurch gekennzeichnet, dass** aus den Messsignalen die Leistung des Hochfrequenzausgangssignals bestimmt wird.

5. Verfahren nach einem der vorhergehenden Ansprüche, weiter **dadurch gekennzeichnet, dass** mindestens ein erstes weiteres Messsignal, das mit der Amplitude des Stroms und/oder der Amplitude der Spannung des überlagerten Signals aus dem Hochfrequenzausgangssignal und dem von der Last reflektierten Hochfrequenzsignal in Beziehung steht, erzeugt wird und dass unter Verwendung des ersten weiteren Messsignals der Reflexionsphasenwinkel ($\varphi$) zwischen dem Hochfrequenzausgangssignal und dem von der an die Plasmaversorgungseinrichtung angeschossene Last reflektierten Hochfrequenzsignal bestimmt wird.

6. Verfahren nach einem der vorhergehenden Ansprüche, weiter **dadurch gekennzeichnet, dass** mindestens ein zweites weiteres Messsignal, das mit der Amplitude des Hochfrequenzstroms durch den Koppler in Beziehung steht, erzeugt wird und dass unter Verwendung des zweiten Messsignals der Reflexionsphasenwinkel ($\varphi$) zwischen dem Hochfrequenzausgangssignal und dem von der an die Plasmaversorgungseinrichtung angeschlossenen Last reflektierten Hochfrequenzsignal bestimmt wird.

7. Verfahren nach einem der vorhergehenden Ansprüche, weiter **dadurch gekennzeichnet, dass** mindestens eines der Messsignale digitalisiert wird und die weitere Verarbeitung digital erfolgt.

8. Verfahren nach einem vorhergehenden Ansprüche, weiter **dadurch gekennzeichnet, dass** die Verarbeitung der Messsignale mit Hilfe mindestens einer Tabelle erfolgt.

9. Verfahren nach einem der vorhergehenden Ansprüche, weiter **dadurch gekennzeichnet, dass** der bestimmte Reflexionsphasenwinkel ($\varphi$) oder die bestimmte Leistung des Hochfrequenzausgangssignals zur Steuerung oder Regelung der erzeugten Hochfrequenzausgangsleistung oder zur Steuerung oder Regelung einer Impedanzanpassungsschaltung verwendet wird.

10. Vorrichtung zum Bestimmen zumindest eines mit einer an eine Plasmalast (60) mit einer dynamischen impedanz durch eine Plasmaversorgungseinrichtung (1) gelieferten Leistung und/oder von der Plasmalast (60) reflektierten Leistung in Beziehung stehenden Parameters, wobei die Plasmaversorgungseinrichtung (1) zwei Hochfrequenzquellen (10, 20) und einen Hybridkoppler (30) umfasst und die Ausgänge der beiden Hochfrequenzquellen (10, 20) an zwei Tore (31, 32) des Hybridkopplers (30) angeschlossen sind, an dessen drittes Tor (33) eine Plasmalast (60) mit dynamischer Impedanz anschließbar ist, **dadurch gekennzeichnet, dass**

   - jeder der beiden Hochfrequenzquellen (10, 20) eine erste Messeinrichtung (110, 120) zugeordnet ist, die Messsignale erzeugen, die mit der Gleichstromleistungsaufnahme der jeweiligen Hochfrequenzquelle (10, 20) in Beziehung stehen, und
   - die ersten Messeinrichtungen (110, 120) an eine Auswerteeinrichtung (150) angeschlossen sind, die ausgebildet ist, aus den Messsignalen mindestens einen Reflexionsphasenwinkel ($\varphi$), der zwischen dem Hochfrequenzausgangssignal und dem von der Plasmalast reflektierten Hochfrequenzsignal vorliegt, zu ermitteln.

11. Vorrichtung nach Anspruch 10, weiter **dadurch gekennzeichnet, dass** mindestens eine weitere Messeinrichtung (130, 190, 200) zur Erzeugung eines Messsignals, das mit der Amplitude der Spannung oder der Amplitude des Stroms des Hochfrequenzausgangssignals oder mit der Amplitude des Stroms durch den Hybridkoppler (30) in Beziehung steht, vorgesehen ist und dass die ersten und weiter(en) Messeinrichtung(en) (110, 120, 130, 190, 200) an die Auswerteeinheit (150) angeschlossen sind.

12. Vorrichtung nach einem der Ansprüche 10 oder 11, weiter **dadurch gekennzeichnet, dass** mindestens ein A/D-Wandler (115, 125, 135, 195, 205) zwischen mindestens einer Messeinrichtung (110, 120, 130, 190, 200) und der Auswerteeinrichtung (150) geschaltet ist und die Auswerteeinrichtung (150) eine digitale Schaltung, insbesondere einen digitalen Signalprozessor, aufweist.

13. Vorrichtung nach Anspruch 12, weiter **dadurch gekennzeichnet, dass** die Auswerteeinrichtung (150) mindestens eine Tabelle enthält.

14. Vorrichtung nach einem der Ansprüche 10 bis 13, weiter **dadurch gekennzeichnet, dass** eine Steuerleitung (160, 170) von der Auswerteeinrichtung (150) zu den Hochfrequenzquellen (10, 20) führt.

15. Vorrichtung nach einem der Ansprüche 10 bis 14, weiter **dadurch gekennzeichnet, dass** zwischen dem Hybridkoppler (30) und der Plasmalast (60) eine Impedanzanpassungssschaltung (50) angeschlossen ist und eine Steuerleitung (180) von der Auswerteschaltung (150) zur Impedanzanpassungsschaltung (50) führt.

**Claims**

1. Method for establishing at least one parameter which is related to a power which is supplied by a plasma supply device to a plasma load with a dynamic impedance and/or a power which is reflected by the plasma load, having the steps of

   - producing two high-frequency source signals of the same frequency with a 90˚ phase shift relative to each other,
   - coupling the high-frequency source signals in a hybrid coupler to form a high-frequency output signal,
   - transmitting the high-frequency output signal to the plasma load,
   - detecting at least one measurement signal respectively which is related to the direct-current power input of the respective high-frequency source,
   - establishing, by means of the measurement signals, a reflection phase angle ($\varphi$) between the high-frequency output signal and the high-frequency signal reflected by the plasma load.

2. Method according to claim 1, further **characterised in that** signals which are related to the input direct currents of the high-frequency sources are used as measurement signals.

3. Method according to either of the preceding claims, further **characterised in that** initially a preliminary reflection phase angle ($\varphi$) is established using the measurement signals.

4. Method according to any one of the preceding claims, further **characterised in that** the power of the high-frequency output signal is established from the measurement signals.

5. Method according to any one of the preceding claims, further **characterised in that** at least a first additional measurement signal which is related to the amplitude of the electric current and/or the amplitude of the voltage of the superimposed signal from the high-frequency output signal and the high-frequency signal reflected by the load is produced, and **in that**, using the first additional measurement signal, the reflection phase angle ($\varphi$) is established between the high-frequency output signal and the high-frequency signal reflected by the load connected to the plasma supply device.

6. Method according to any one of the preceding claims, further **characterised in that** at least a second additional measurement signal which is related to the amplitude of the high-frequency current through the coupler is produced and **in that**, using the second measurement signal, the reflection phase angle ($\varphi$) is established between the high-frequency output signal and the high-frequency signal reflected by the load connected to the plasma supply device.

7. Method according to any one of the preceding claims, further **characterised in that** at least one of the measurement signals is digitised and the subsequent processing is carried out digitally.

8. Method according to any one of the preceding claims, further **characterised in that** the measurement signals are processed with reference to at least one table.

9. Method according to any one of the preceding claims, further **characterised in that** the established reflection phase angle ($\varphi$) or the established power of the high-frequency output signal is used to control or regulate the high-frequency output power produced or to control or regulate an impedance matching circuit.

10. Device for establishing at least one parameter which is related to a power which is supplied to a plasma load (60) with a dynamic impedance by a plasma supply device (1) and/or a power which is reflected by the plasma load (60), the plasma supply device (1) comprising two high-frequency sources (10, 20) and a hybrid coupler (30) and the outputs of the two high-frequency sources (10, 20) being connected to two ports (31, 32) of the hybrid coupler (30), to a third port (33) of which a plasma load (60) with a dynamic impedance can be connected, **characterised in that**

    - a first measurement device (110, 120) is associated with each of the two high-frequency sources (10, 20), respectively, producing measurement signals which are related to the direct-current power input of the respective high-frequency source (10, 20) and
    - the first measurement devices (110, 120) are connected to an evaluation device (150) which is constructed to establish from the measurement signals at least one reflection phase angle ($\varphi$) which is present between the high-frequency output signal and the high-frequency signal reflected by the plasma load.

11. Device according to claim 10, further **characterised in that** at least one additional measurement device (130, 190, 200) is provided to produce a measurement signal which is related to the amplitude of the voltage or the amplitude of the electric current of the high-frequency output signal or the amplitude of the electric current through the hybrid coupler (30), and **in that** the first and additional measurement device(s) (110, 120, 130, 190, 200) are connected to the evaluation unit (150).

12. Device according to either claim 10 or claim 11, further **characterised in that** at least one A/D converter (115, 125, 135, 195, 205) is connected between at least one measurement device (110, 120, 130, 190, 200) and the evaluation device (150), and the evaluation device (150) has a digital circuit, in particular a digital signal processor.

13. Device according to claim 12, further **characterised in that** the evaluation device (150) contains at least one table.

14. Device according to any one of claims 10 to 13, further **characterised in that** a control line (160, 170) extends from the evaluation device (150) to the high-frequency sources (10, 20).

15. Device according to any one of claims 10 to 14, further **characterised in that** an impedance matching circuit (50) is connected between the hybrid coupler (30) and the plasma load (60) and a control line (180) extends from the evaluation circuit (150) to the impedance matching circuit (50).

**Revendications**

1. Procédé pour déterminer au moins un paramètre en rapport avec une puissance fournie à une charge de plasma ayant une impédance dynamique par un dispositif d'alimentation en plasma et/ou avec une puissance réfléchie par la charge de plasma, comprenant les étapes suivantes :

   - génération de deux signaux de source haute fréquence de même fréquence déphasés de 90° l'un par rapport à l'autre,
   - couplage des signaux de source haute fréquence dans un coupleur hybride délivrant un signal de sortie haute fréquence,
   - envoi du signal de sortie haute fréquence à la charge de plasma,
   - détection de chaque fois au moins un signal de mesure qui est en rapport avec la puissance consommée en courant continu de la source haute fréquence respective,
   - à l'aide des signaux de mesure, détermination d'un angle de phase de réflexion ($\varphi$) entre le signal de sortie haute fréquence et le signal haute fréquence réfléchi par la charge de plasma.

2. Procédé selon la revendication 1, **caractérisé en outre en ce que** l'on utilise comme signaux de mesure des signaux qui sont en rapport avec les courants continus d'entrée des sources haute fréquence.

3. Procédé selon une des revendications précédentes, **caractérisé en outre en ce que** l'on détermine d'abord un angle de phase de réflexion ($\varphi$) provisoire en utilisant les signaux de mesure.

4. Procédé selon une des revendications précédentes, **caractérisé en outre en ce que** l'on détermine la puissance du signal de sortie haute fréquence à partir des signaux de mesure.

5. Procédé selon une des revendications précédentes, **caractérisé en outre en ce qu'**au moins un premier autre signal de mesure qui est en rapport avec l'amplitude du courant et/ou l'amplitude de la tension du signal superposé composé du signal de sortie haute fréquence et du signal haute fréquence réfléchi par la charge est généré et que l'angle de phase de réflexion ($\varphi$) entre le signal de sortie haute fréquence et le signal haute fréquence réfléchi par la charge connectée au dispositif d'alimentation en plasma est déterminé en utilisant le premier autre signal de mesure.

6. Procédé selon une des revendications précédentes, **caractérisé en outre en ce qu'**au moins un deuxième autre signal de mesure qui est en rapport avec l'amplitude du courant haute fréquence à travers le coupleur est généré et que l'angle de phase de réflexion ($\varphi$) entre le signal de sortie haute fréquence et le signal haute fréquence réfléchi par la charge connectée au dispositif d'alimentation en plasma est déterminé en utilisant le deuxième signal de mesure.

**7.** Procédé selon une des revendications précédentes, **caractérisé en outre en ce qu'**au moins un des signaux de mesure est numérisé et que la suite du traitement s'effectue numériquement.

**8.** Procédé selon une des revendications précédentes, **caractérisé en outre en ce que** le traitement des signaux de mesure s'effectue à l'aide d'au moins un tableau.

**9.** Procédé selon une des revendications précédentes, **caractérisé en outre en ce que** l'angle de phase de réflexion ($\varphi$) déterminé ou la puissance déterminée du signal de sortie haute fréquence est utilisé(e) pour commander ou réguler la puissance de sortie haute fréquence générée ou pour commander ou réguler un circuit d'adaptation d'impédance.

**10.** Dispositif pour déterminer au moins un paramètre en rapport avec une puissance fournie à une charge de plasma (60) ayant une impédance dynamique par un dispositif d'alimentation en plasma (1) et/ou avec une puissance réfléchie par la charge de plasma (60), le dispositif d'alimentation en plasma (1) comprenant deux sources haute fréquence (10, 20) et un coupleur hybride (30) et les sorties des deux sources haute fréquence (10, 20) étant connectées à deux portes (31, 32) du coupleur hybride (30) à la troisième porte (33) duquel peut être connectée une charge de plasma (60) ayant une impédance dynamique, **caractérisé en ce que**

- à chacune des deux sources haute fréquence (10, 20) est associé un premier dispositif de mesure (110, 120) qui génèrent des signaux de mesure qui sont en rapport avec la puissance consommée en courant continu de la source haute fréquence (10, 20) respective, et
- les premiers dispositifs de mesure (110, 120) sont connectés à un dispositif d'évaluation (150) qui est conçu pour déterminer au moins un angle de phase de réflexion ($\varphi$) qui existe entre le signal de sortie haute fréquence et le signal haute fréquence réfléchi par la charge de plasma à partir des signaux de mesure.

**11.** Dispositif selon la revendication 10, **caractérisé en outre en ce qu'**il est prévu au moins un autre dispositif de mesure (130, 190, 200) pour générer un signal de mesure qui est en rapport avec l'amplitude de la tension ou l'amplitude du courant du signal de sortie haute fréquence ou avec l'amplitude du courant à travers le coupleur hybride (30) et que les premiers et le ou les autre(s) dispositif(s) de mesure (110, 120, 130, 190, 200) sont connectés à l'unité d'évaluation (150).

**12.** Dispositif selon une des revendications 10 ou 11, **caractérisé en outre en ce qu'**au moins un convertisseur A/N (115, 125, 135, 195, 205) est monté entre au moins un dispositif de mesure (110, 120, 130, 190, 200) et le dispositif d'évaluation (150) et le dispositif d'évaluation (150) présente un circuit numérique, en particulier un processeur de signaux numériques.

**13.** Dispositif selon la revendication 12, **caractérisé en outre en ce que** le dispositif d'évaluation (150) contient au moins un tableau.

**14.** Dispositif selon une des revendications 10 à 13, **caractérisé en outre en ce qu'**une ligne de commande (160, 170) mène du dispositif d'évaluation (150) aux sources haute fréquence (10, 20).

**15.** Dispositif selon une des revendications 10 à 14, **caractérisé en outre en ce qu'**un circuit d'adaptation d'impédance (50) est connecté entre le coupleur hybride (30) et la charge de plasma (60) et qu'une ligne de commande (180) mène du circuit d'évaluation (150) au circuit d'adaptation d'impédance (50).

Fig. 1

# Fig. 2

# Fig. 3

Fig. 4

Fig. 5

Fig. 6

Fig. 7

**IN DER BESCHREIBUNG AUFGEFÜHRTE DOKUMENTE**

**In der Beschreibung aufgeführte Patentdokumente**

- EP 1701376 A1